# FASCICULE DE BREVET EUROPEEN

(11) **EP 3 036 352 B1**
(45) Date de publication et mention de la délivrance du brevet: **01.03.2017**
(21) Numéro de dépôt: 14790166.4
(22) Date de dépôt: 31.07.2014
(51) Int. Cl.: C23C 14/02, C23C 14/58, C23C 14/14, C23C 14/20, C23C 14/18, C03C 17/36, C23C 28/00

(54) **PROCEDE D'OBTENTION D'UN SUBSTRAT MUNI D'UN REVETEMENT COMPRENANT UNE COUCHE MINCE METALLIQUE DISCONTINUE**
VERFAHREN ZUR HERSTELLUNG EINES SUBSTRATS MIT EINER BESCHICHTUNG MIT EINER DISKONTINUIERLICHEN DÜNNEN METALLSCHICHT
METHOD FOR OBTAINING A SUBSTRATE PROVIDED WITH A COATING COMPRISING A DISCONTINUOUS THIN METAL LAYER

(30) Priorité: 20.08.2013 FR 1358063
(43) Date de publication de la demande: 29.06.2016
(73) Titulaire: Saint-Gobain Glass France, 92400 Courbevoie (FR)
(72) Inventeur: PALACIOS-LALOY, Augustin, F-38120 Saint Egrève (FR)
(74) Mandataire: Saint-Gobain Recherche
(86) Numéro de dépôt international: PCT/FR2014/051999
(87) Numéro de publication internationale: WO 2015/025093

(56) Documents cités:
- US-A1- 2013 183 492
- SAGAR YADAVALI ET AL: "Pulsed laser dewetting of Au films: Experiments and modeling of nanoscale behavior", JOURNAL OF MATERIALS RESEARCH, vol. 28, no. 13, 14 mai 2013 (2013-05-14), pages 1715-1723, XP055126778, ISSN: 0884-2914, DOI: 10.1557/jmr.2013.90
- FANG YI ET AL: "Characterization of nanoscale clusters fabricated by pulsed laser irradiation of thin Au films", APPLIED SURFACE SCIENCE, ELSEVIER, AMSTERDAM, NL, vol. 273, 4 mars 2013 (2013-03-04), pages 625-631, XP028579441, ISSN: 0169-4332, DOI: 10.1016/J.APSUSC.2013.02.090
- YURI S. KAGANOVSKII: "Fabrication of periodic structures in thin metal films by pulsed laser irradiation", JOURNAL OF NANOPHOTONICS, vol. 1, no. 1, 1 décembre 2007 (2007-12-01), page 011690, XP055077062, ISSN: 1934-2608, DOI: 10.1117/1.2824477
- RIEDEL S ET AL: "Nanostructuring of thin films by ns pulsed laser interference", APPLIED PHYSICS A; MATERIALS SCIENCE & PROCESSING, SPRINGER, BERLIN, DE, vol. 101, no. 2, 16 juin 2010 (2010-06-16) , pages 309-312, XP019844762, ISSN: 1432-0630

## Description

L'invention se rapporte au domaine des matériaux comprenant un substrat revêtu par au moins un revêtement texturé à l'échelle nanométrique ou micrométriques.

Ces revêtements texturés, se présentant sous la forme de motifs géométriques, possèdent des applications multiples, dans un grand nombre de domaines. Des revêtements se présentant sous la forme de lignes disjointes périodiquement réparties trouvent notamment des applications dans les domaines de l'optique, de l'électronique ou encore de l'optoélectronique, par exemple en tant que polariseurs ou électrodes.

De tels revêtements sont habituellement obtenus par des techniques telles que la photolithographie ou la lithographie par nano-impression. Outre leur coût élevé, ces techniques ne permettent pas de traiter des substrats de grande taille, par exemple de plusieurs mètres carrés.

Il existe un besoin de pouvoir texturer des revêtements de manière beaucoup plus économique. Pouvoir texturer des revêtements de grande taille permettrait également d'élargir les champs d'application de ces matériaux, par exemple dans le domaine du bâtiment.

A cet effet, un premier objet de l'invention est un procédé d'obtention d'un matériau comprenant un substrat revêtu sur au moins une partie d'au moins une de ses faces par un revêtement comprenant au moins une couche mince métallique discontinue à base d'argent, d'or, ou d'un quelconque de leurs alliages, la ou chaque couche mince métallique discontinue étant encapsulée entre au moins deux couches minces diélectriques, et la ou chaque couche mince métallique discontinue se présentant sous la forme de motifs géométriques périodiques. Ce procédé comprend les étapes suivantes :
- on dépose sur au moins une partie d'au moins une face d'un substrat un revêtement comprenant au moins une couche mince métallique continue à base d'argent, d'or, ou d'un quelconque de leurs alliages, puis
- on fait défiler le substrat ainsi revêtu en regard d'au moins un dispositif laser émettant un rayonnement laser focalisé sur ledit revêtement sous la forme d'au moins une ligne, la puissance dudit rayonnement étant adaptée afin de rendre discontinue la ou chaque couche mince métallique par démouillage.

Un autre objet de l'invention est un matériau susceptible d'être obtenu par le procédé selon l'invention, comprenant un substrat revêtu sur au moins une partie d'au moins une de ses faces par un revêtement comprenant au moins une couche mince métallique discontinue à base d'argent, d'or, ou d'un quelconque de leurs alliages, la ou chaque couche mince métallique discontinue étant encapsulée entre au moins deux couches minces diélectriques, et la ou chaque couche mince métallique discontinue se présentant sous la forme de motifs géométriques périodiques.

Cette méthode d'obtention de revêtements texturés à motifs géométriques périodiques est bien plus économique et plus rapide que les techniques connues, notamment celles basées sur la lithographie, puisque dans sa forme la plus simple elle comprend une étape de dépôt du revêtement, suivie d'une étape de traitement dans lequel le revêtement défile sous une ligne laser. Ces deux étapes peuvent en outre être réalisées sur des substrats de grande taille.

Les inventeurs ont pu mettre en évidence que le traitement laser, à partir d'une certaine puissance, entraînait le démouillage de la couche métallique, qui de continue à l'origine, devient discontinue de manière à former des motifs. Sans que la raison scientifique en soit connue, le démouillage réalisé dans de telles conditions donne naissance à la formation de motifs périodiques, à l'échelle nanométrique ou micrométrique.

Par le terme « discontinue », on entend que la (ou chaque) couche mince métallique ne couvre qu'une partie de la couche sous-jacente. Après démouillage, donc dans le matériau final, la (ou chaque) couche mince métallique couvre de préférence de 30 à 60% de la surface de la couche sous-jacente, typiquement de l'ordre de 50%.

Par l'expression « la ou chaque couche mince métallique discontinue étant encapsulée entre au moins deux couches minces diélectriques », on entend que des couches diélectriques sont disposées autour de la ou chaque couche mince : une au moins en-dessous (plus proche du substrat) et une au moins au-dessus (plus éloignée du substrat). Les couches minces diélectriques ne sont toutefois pas nécessairement en contact avec la couche métallique qu'elles entourent, comme explicité plus en détail dans la suite du texte.

De préférence, le substrat est revêtu sur la totalité d'une de ses faces. Le revêtement, qu'il soit intermédiaire (avant traitement laser) ou final (après traitement laser) comprend avantageusement une seule couche mince métallique, notamment à base de, voire constituée d'argent.

La (ou le cas échéant chaque) couche mince métallique est de préférence essentiellement constituée, voire constituée d'argent, d'or, ou d'un quelconque de leurs alliages. De préférence, la (ou chaque) couche mince métallique est constituée d'argent. L'argent peut être aisément déposé, notamment par pulvérisation cathodique, et possède des propriétés intéressantes tant optiques qu'électriques, notamment de conductivité électrique, de faible émissivité, de réflexion dans le domaine de l'infrarouge. L'or possède également des propriétés intéressantes, mais pour un coût bien plus élevé.

Les motifs géométriques périodiques possèdent de préférence une période comprise dans un domaine allant de 0,1 à 10 micromètres, notamment de 0,3 à 5 micromètres, et même de 0,4 à 4 micromètres. Ces motifs se répétant à l'échelle de la centaine de nanomètres ou du micromètre présentent des propriétés particulièrement intéressantes, comme détaillé dans la suite du texte.

La période des motifs géométriques peut être réglée à l'aide de différents paramètres, en particulier :
- la longueur d'onde du rayonnement laser ; typiquement, lorsque la ligne laser est perpendiculaire à la direction de défilement, la période est de l'ordre du double de la longueur d'onde du rayonnement laser.
- l'angle entre la ligne laser et la direction de défilement. La période est en effet sensiblement proportionnelle au sinus de cet angle.
- les épaisseurs et indices de réfraction des couches du revêtement, qui contrôlent les phénomènes d'interférence du rayonnement laser.
- la nature chimique et l'épaisseur de la couche sous-jacente, située sous la couche métallique, en contact direct avec elle ; Cette couche influence en effet les propriétés de mouillage de l'argent.

Dans un mode de réalisation particulièrement avantageux, les motifs géométriques obtenus sont des lignes s'étendant dans la direction de défilement du substrat. Les motifs géométriques du matériau final sont donc des lignes. A partir d'une certaine puissance du rayonnement laser, le démouillage de la (ou chaque) couche mince métallique commence en effet à créer de manière spontanée des lignes de métal (notamment d'argent) dans la direction de défilement du substrat. Comme indiqué précédemment, la période de ces lignes est de l'ordre du double de la longueur d'onde du rayonnement laser, multiplié par le sinus de l'angle formé par la ligne laser et la direction de défilement.

De préférence, la largeur des lignes est de l'ordre de la demi-période, voire est égale à la demi-période. Cette largeur est avantageusement comprise dans un domaine allant de 0,05 à 5 micromètres, notamment de 0,15 à 2,5 micromètres, et même de 0,2 à 2 micromètres. La zone occupée par ces lignes représente de préférence de 40 à 60% de la surface de la couche sous-jacente, typiquement de l'ordre de 50%. Ainsi, la largeur des zones non-revêtues par la (ou chaque) couche mince métallique est de préférence comprise dans un domaine allant de 0,05 à 5 micromètres, notamment de 0,15 à 2,5 micromètres, et même de 0,2 à 2 micromètres. Dans les applications de polarisation de la lumière, le choix de la période est important puisqu'il permet de polariser un rayonnement dont la longueur d'onde est de l'ordre de cette période.

Selon un autre mode de réalisation préféré, les motifs périodiques possèdent une périodicité selon au moins deux axes non parallèles entre eux. Les motifs périodiques peuvent notamment être des gouttes de tailles et de formes sensiblement identiques, régulièrement espacées, et ordonnées périodiquement selon plusieurs axes non parallèles entre eux. Les gouttes peuvent notamment s'ordonner de manière à ce que chaque goutte soit le centre d'un hexagone, notamment régulier, dont les sommets sont les six gouttes les plus proches de la goutte considérée. Les gouttes peuvent présenter une forme sensiblement elliptique ou circulaire. Il s'est en effet avéré qu'en augmentant la puissance du rayonnement laser à des niveaux supérieurs à ceux créant les motifs linéaires (ou, comme on le verra plus loin, en diminuant la vitesse de défilement), les lignes préalablement formées se mettaient elles-mêmes à démouiller pour former de telles gouttes. Dans un stade intermédiaire (donc pour une puissance ou une vitesse de défilement intermédiaire), les motifs se présentent alors sous la forme de lignes dont la largeur varie périodiquement. Les gouttes ne sont en effet pas encore disjointes.

L'épaisseur physique de la ou chaque couche mince métallique (notamment en argent) continue est de préférence comprise dans un domaine allant de 2 à 20 nm.

Le revêtement (avant ou après traitement) comprend de préférence, à partir du substrat, un premier revêtement comprenant au moins une première couche diélectrique, au moins une couche mince métallique (notamment d'argent), éventuellement une couche de sur-bloqueur et un deuxième revêtement comprenant au moins une deuxième couche diélectrique. Ainsi, la couche mince métallique est-elle encapsulée entre aux moins deux couches diélectriques.

La couche de sur-bloqueur est destinée à protéger la couche métallique pendant le dépôt d'une couche ultérieure (par exemple si cette dernière est déposée sous atmosphère oxydante ou nitrurante) et pendant un éventuel traitement thermique du type trempe ou bombage.

La couche métallique peut également être déposée sur et en contact avec une couche de sous-bloqueur. L'empilement peut donc comprendre une couche de sur-bloqueur et/ou une couche de sous-bloqueur encadrant la ou chaque couche métallique.

Les couches de bloqueur (sous-bloqueur et/ou sur-bloqueur) sont généralement à base d'un métal choisi parmi le nickel, le chrome, le titane, le niobium, ou d'un alliage de ces différents métaux. On peut notamment citer les alliages nickel-titane (notamment ceux comprenant environ 50% en poids de chaque métal) ou les alliages nickel-chrome (notamment ceux comprenant 80% en poids de nickel et 20% en poids de chrome). La couche de sur-bloqueur peut encore être constituée de plusieurs couches superposées, par exemple, en s'éloignant du substrat, de titane puis d'un alliage de nickel (notamment un alliage nickel-chrome) ou l'inverse. Les différents métaux ou alliages cités peuvent également être partiellement oxydés, notamment présenter une sous-stoechiométrie en oxygène (par exemple TiOₓ ou NiCrOₓ).

Ces couches de bloqueur (sous-bloqueur et/ou sur-bloqueur) sont très fines, normalement d'une épaisseur inférieure à 1 nm, pour ne pas affecter la transmission lumineuse de l'empilement, et sont susceptibles d'être partiellement oxydées pendant le traitement laser. D'une manière générale les couches de bloqueur sont des couches sacrificielles, susceptibles de capter l'oxygène provenant de l'atmosphère ou du substrat, évitant ainsi l'oxydation de la couche métallique. Il est donc possible que dans le produit final les couches de bloqueur soient au moins partiellement oxydées.

La première et/ou la deuxième couche diélectrique est de préférence en oxyde (notamment en oxyde d'étain ou de titane), ou en nitrure, notamment en nitrure de silicium (en particulier pour la deuxième couche diélectrique, la plus éloignée du substrat). D'une manière générale, le nitrure de silicium peut être dopé, par exemple avec de l'aluminium ou du bore, afin de faciliter son dépôt par les techniques de pulvérisation cathodique. Le taux de dopage (correspondant au pourcentage atomique par rapport à la quantité de silicium) ne dépasse généralement pas 2%. Ces couches diélectriques ont pour fonction de protéger la couche métallique des agressions chimiques ou mécaniques et influent également sur les propriétés optiques, notamment en réflexion, de l'empilement, grâce à des phénomènes interférentiels.

Le premier revêtement peut comprendre une couche diélectrique, ou plusieurs couches diélectriques, typiquement 2 à 4. Le deuxième revêtement peut comprendre une couche diélectrique, ou plusieurs couches diélectriques, typiquement 2 à 3. Ces couches diélectriques sont de préférence en un matériau choisi parmi le nitrure de silicium, les oxydes de titane, d'étain ou de zinc, ou l'un quelconque de leurs mélanges ou solutions solides, par exemple un oxyde d'étain et de zinc, ou un oxyde de titane et de zinc. Que ce soit dans le premier revêtement ou dans le deuxième revêtement, l'épaisseur physique de la couche diélectrique, ou l'épaisseur physique globale de l'ensemble des couches diélectriques, est de préférence comprise entre 5 et 200 nm, notamment 10 et 100 nm, voire entre 20 et 50 nm.

Le premier revêtement comprend de préférence, immédiatement sous la couche métallique (notamment d'argent) ou sous l'éventuelle couche de sous-bloqueur, une couche de mouillage dont la fonction est d'augmenter le mouillage et l'accrochage de la couche métallique (notamment d'argent). L'oxyde de zinc, notamment dopé à l'aluminium, s'est révélé particulièrement avantageux à cet égard.

Le premier revêtement peut également contenir, directement sous la couche de mouillage, une couche de lissage, qui est un oxyde mixte partiellement voire totalement amorphe (donc de très faible rugosité), dont la fonction est de favoriser la croissance de la couche de mouillage selon une orientation cristallographique préférentielle, laquelle favorise la cristallisation de l'argent par des phénomènes d'épitaxie. La couche de lissage est de préférence composée d'un oxyde mixte d'au moins deux métaux choisis parmi Sn, Zn, In, Ga, Sb. Un oxyde préféré est l'oxyde d'étain et d'indium dopé à l'antimoine.

Dans le premier revêtement, la couche de mouillage ou l'éventuelle couche de lissage est de préférence déposée directement sur la première couche diélectrique. La première couche diélectrique est de préférence déposée directement sur le substrat. Pour adapter au mieux les propriétés optiques de l'empilement (notamment l'aspect en réflexion), la première couche diélectrique peut alternativement être déposée sur une autre couche en oxyde ou en nitrure, par exemple en oxyde de titane.

Au sein du deuxième revêtement, la deuxième couche diélectrique peut être déposée directement sur la couche métallique (notamment d'argent), ou de préférence sur un sur-bloqueur, ou encore sur d'autres couches en oxyde ou en nitrure, destinées à adapter les propriétés optiques de l'empilement. Par exemple, une couche d'oxyde de zinc, notamment dopé à l'aluminium, ou encore une couche d'oxyde d'étain, peut être disposée entre un sur-bloqueur et la deuxième couche diélectrique, qui est de préférence en nitrure de silicium. L'oxyde de zinc, notamment dopé à l'aluminium, permet d'améliorer l'adhésion entre le métal (notamment l'argent) et les couches supérieures.

Ainsi, le revêtement (avant ou après traitement) comprend de préférence au moins une succession ZnO / Ag / ZnO. L'oxyde de zinc peut être dopé à l'aluminium. Une couche de sous-bloqueur peut être disposée entre la couche d'argent et la couche sous-jacente. Alternativement ou cumulativement, une couche de sur-bloqueur peut être disposée entre la couche d'argent et la couche sus-jacente.

Enfin, le deuxième revêtement peut être surmonté d'une surcouche, parfois appelée « overcoat » dans la technique. Dernière couche de l'empilement, donc en contact avec l'air ambiant, elle est destinée à protéger l'empilement contre toutes agressions mécaniques (rayures...) ou chimiques. Cette surcouche est généralement très fine pour ne pas perturber l'aspect en réflexion de l'empilement (son épaisseur est typiquement comprise entre 1 et 5 nm). Elle est de préférence à base d'oxyde de titane ou d'oxyde mixte d'étain et de zinc, notamment dopé à l'antimoine, déposé sous forme sous-stoechiométrique.

L'empilement peut comprendre une ou plusieurs couches métalliques (notamment d'argent), notamment deux ou trois couches d'argent. Lorsque plusieurs couches métalliques (notamment d'argent) sont présentes, l'architecture générale présentée ci-avant peut être répétée. Dans ce cas, le deuxième revêtement relatif à une couche métallique (notamment d'argent) donnée (donc situé au-dessus de cette couche métallique) coïncide généralement avec le premier revêtement relatif à la couche métallique suivante.

Les couches minces à base d'oxyde de titane ont la particularité d'être autonettoyantes, en facilitant la dégradation des composés organiques sous l'action de rayonnements ultraviolets et l'élimination des salissures minérales (poussières) sous l'action d'un ruissellement d'eau. Leur épaisseur physique est de préférence comprise entre 2 et 50 nm, notamment entre 5 et 20 nm, bornes comprises.

L'architecture du revêtement décrite ci-avant vaut autant pour le revêtement avant traitement laser qu'après ledit traitement laser. Le démouillage de la couche métallique ne modifie en effet pas l'ordre des couches. Le déouillage de la couche métallique modifie toutefois l'épaisseur du revêtement, qui devient irrégulière : plus épaisse dans les zones revêtues par le métal, moins épaisses dans les zones non-revêtues. Dans ces dernières zones, le démouillage du métal a en outre pour effet de mettre en contact les couches auparavant séparées par la couche métallique, par exemple la couche de mouillage et la couche de sur-bloqueur.

Selon l'invention, au moins un dispositif laser émet un rayonnement laser focalisé sur ledit revêtement sous la forme d'au moins une ligne. La ou chaque ligne sera appelée « ligne laser » dans la suite du texte.

Les lasers sont généralement constitués de modules comprenant une ou plusieurs sources laser ainsi que des optiques de mise en forme et de redirection.

Les sources laser sont typiquement des diodes laser ou des lasers à fibre ou à disque. Les diodes laser permettent d'atteindre de manière économique de fortes densités de puissance par rapport à la puissance électrique d'alimentation pour un faible encombrement. L'encombrement des lasers à fibres est encore plus réduit, et la puissance linéique obtenue peut être encore plus élevée, pour un coût toutefois plus important.

Le rayonnement issu des sources laser peut être continu ou pulsé, de préférence continu. Lorsque le rayonnement est pulsé, la fréquence de répétition est avantageusement d'au moins 10 kHz, notamment 15 kHz et même 20 kHz de manière à être compatible avec les grandes vitesses de déplacement utilisées.

La longueur d'onde du rayonnement laser est de préférence comprise dans un domaine allant de 200 à 2000 nm, notamment de 500 à 1500 nm. Des diodes laser de puissance émettant à au moins une longueur d'onde choisie parmi 808 nm, 880 nm, 915 nm, 940 nm ou 980 nm se sont révélées particulièrement bien appropriées, l'argent et l'or absorbant ce type de rayonnement de manière satisfaisante.

Les optiques de mise en forme et de redirection comprennent de préférence des lentilles et des miroirs, et sont utilisées comme moyens de positionnement, d'homogénéisation et de focalisation du rayonnement.

Les moyens de positionnement ont pour but le cas échéant de disposer selon une ligne les rayonnements émis par les sources laser. Ils comprennent de préférence des miroirs. Les moyens d'homogénéisation ont pour but de superposer les profils spatiaux des sources laser afin d'obtenir une puissance linéique homogène tout au long de la ligne. Les moyens d'homogénéisation comprennent de préférence des lentilles permettant la séparation des faisceaux incidents en faisceaux secondaires et la recombinaison desdits faisceaux secondaires en une ligne homogène. Les moyens de focalisation du rayonnement permettent de focaliser le rayonnement sur le revêtement à traiter, sous la forme d'une ligne de longueur et de largeur voulues. Les moyens de focalisation comprennent de préférence une lentille convergente.

La ou chaque ligne possède une longueur et une largeur. On entend par « longueur » de la ligne la plus grande dimension de la ligne, mesurée sur la surface du revêtement, et par « largeur » la dimension selon une direction transversale à la direction de la plus grande dimension. Comme il est d'usage dans le domaine des lasers, la largeur w de la ligne correspond à la distance (selon cette direction transversale) entre l'axe du faisceau (où l'intensité du rayonnement est maximale) et le point où l'intensité du rayonnement est égale à 1/e² fois l'intensité maximale. Si l'axe longitudinal de la ligne laser est nommé x, on peut définir une distribution de largeurs selon cet axe, nommée w(x).

La largeur moyenne de la ou chaque ligne laser est de préférence d'au moins 35 micromètres, notamment comprise dans un domaine allant de 40 à 100 micromètres ou de 40 à 70 micromètres. Dans l'ensemble du présent texte on entend par « moyenne » la moyenne arithmétique. Sur toute la longueur de la ligne, la distribution de largeurs est étroite afin d'éviter toute hétérogénéité de traitement. Ainsi, la différence entre la largeur la plus grande et la largeur la plus petite vaut de préférence au plus 10% de la valeur de la largeur moyenne. Ce chiffre est de préférence d'au plus 5% et même 3%.

La longueur de la ou chaque ligne laser est de préférence d'au moins 10 cm ou 20 cm, notamment comprise dans un domaine allant de 30 à 100 cm, notamment de 30 à 75 cm, voire de 30 à 60 cm. On peut par exemple utiliser, pour un substrat de 3,3 m de large, 11 lignes de 30 cm de longueur.

Les optiques de mise en forme et de redirection, notamment les moyens de positionnement, peuvent être ajustées manuellement ou à l'aide d'actuateurs permettant de régler leur positionnement à distance. Ces actuateurs (typiquement des moteurs ou des cales piézoélectriques) peuvent être commandés manuellement et/ou être réglés automatiquement. Dans ce dernier cas, les actuateurs seront de préférence connectés à des détecteurs ainsi qu'à une boucle de rétroaction.

Au moins une partie des modules laser, voire leur totalité est de préférence disposée en boîte étanche, avantageusement refroidie, notamment ventilée, afin d'assurer leur stabilité thermique.

Les modules laser sont de préférence montés sur une structure rigide, appelée « pont », à base d'éléments métalliques, typiquement en aluminium. La structure ne comprend de préférence pas de plaque de marbre. Le pont est de préférence positionné de manière parallèle aux moyens de convoyage de sorte que le plan focal de la ou chaque ligne laser reste parallèle à la surface du substrat à traiter. De préférence, le pont comprend au moins quatre pieds, dont la hauteur peut être individuellement ajustée pour assurer un positionnement parallèle en toutes circonstances. L'ajustement peut être assuré par des moteurs situés au niveau de chaque pied, soit manuellement, soit automatiquement, en relation avec un capteur de distance. La hauteur du pont peut être adaptée (manuellement ou automatiquement) pour prendre en compte l'épaisseur du substrat à traiter, et s'assurer ainsi que le plan du substrat coïncide avec le plan focal de la ou chaque ligne laser.

Le démouillage de la ou chaque couche mince métallique peut être obtenu en jouant sur la puissance linéique du laser et/ou la vitesse de défilement du substrat. A même puissance linéique, le démouillage sera obtenu pour des vitesses de défilement plus faibles qu'une valeur seuil. Inversement, à même vitesse de défilement, le démouillage sera obtenu pour des puissances linéiques plus élevées qu'une valeur seuil.

Pour un revêtement donné (et notamment une absorption donnée), le démouillage sera obtenu à partir d'une certaine valeur du rapport entre la puissance linéique (le cas échéant divisée par la racine carrée du rapport cyclique) et la racine carrée de la vitesse de défilement.

Ces valeurs seuils dépendent de plusieurs facteurs : la nature de cette couche métallique, son épaisseur, le type de couches de l'empilement et leurs épaisseurs. La puissance ou la vitesse de défilement adéquate peut aisément être déterminée pour un revêtement donné, en augmentant progressivement la puissance du laser ou en diminuant la vitesse de défilement jusqu'à observer l'apparition des motifs géométriques. En-deçà de la puissance minimale ou au-delà de la vitesse maximale pour obtenir le démouillage, la couche métallique reste continue, et le traitement a surtout pour effet d'améliorer la cristallisation de la couche métallique et ses propriétés électroniques et de faible émissivité.

Notamment pour des empilements comprenant une unique couche d'argent d'épaisseur physique de l'ordre de 10 nm, le rapport entre la puissance linéique et la racine carrée de la vitesse de défilement est avantageusement d'au moins 13 ou 14, notamment compris entre 14 et 15 W.min^{1/2}.cm^{-3/2}.

La puissance linéique divisée par la racine carrée du rapport cyclique des sources laser est de préférence d'au moins 300 W/cm, avantageusement 350 ou 400 W/cm, notamment 450 W/cm, voire 500 W/cm et même 550 W/cm. La puissance linéique divisée par la racine carrée du rapport cyclique est même avantageusement d'au moins 600 W/cm, notamment 800 W/cm, voire 1000 W/cm. Lorsque le rayonnement laser est continu, le rapport cyclique vaut 1, si bien que ce chiffre correspond à la puissance linéique. La puissance linéique est mesurée à l'endroit où la ou chaque ligne laser est focalisée sur le revêtement. Elle peut être mesurée en disposant un détecteur de puissance le long de la ligne, par exemple un puissance-mètre calorimétrique, tel que notamment le puissance-mètre Beam Finder de la société Coherent Inc. La puissance est avantageusement répartie de manière homogène sur toute la longueur de la ou chaque ligne. De préférence, la différence entre la puissance la plus élevée et la puissance la plus faible vaut moins de 10% de la puissance moyenne.

La densité d'énergie fournie au revêtement divisée par la racine carrée du rapport cyclique est de préférence d'au moins 20 J/cm², voire 30 J/cm². Ici encore, le rapport cyclique vaut 1 lorsque le rayonnement laser est continu.

La vitesse de défilement du substrat est avantageusement d'au moins 4 m/min, notamment 5 m/min et même 6 m/min ou 7 m/min, ou encore 8 m/min et même 9 m/min ou 10 m/min. Selon certains modes de réalisation, la vitesse de déplacement du substrat peut être d'au moins 12 m/min ou 15 m/min, notamment 20 m/min et même 25 ou 30 m/min. Comme indiqué précédemment, les vitesses de défilement permettant d'obtenir le démouillage de la couche métallique dépendent de l'empilement, mais peuvent aisément être déterminées. Afin d'assurer un traitement qui soit le plus homogène possible, la vitesse de défilement du substrat varie lors du traitement d'au plus 10% en relatif, notamment 2% et même 1% par rapport à sa valeur nominale.

Afin de renforcer l'efficacité du traitement, il est préférable qu'au moins une partie du rayonnement laser (principal) transmise au travers du substrat et/ou réfléchie par le revêtement soit redirigée en direction dudit substrat pour former au moins un rayonnement laser secondaire, qui de préférence impacte le substrat au même endroit que le rayonnement laser principal, avec avantageusement la même profondeur de foyer et le même profil. La formation du ou de chaque rayonnement laser secondaire met avantageusement en oeuvre un montage optique ne comprenant que des éléments optiques choisis parmi les miroirs, les prismes et les lentilles, notamment un montage optique constitué de deux miroirs et d'une lentille, ou d'un prisme et d'une lentille. En récupérant au moins une partie du rayonnement principal perdu et en le redirigeant vers le substrat, le traitement thermique s'en trouve considérablement amélioré. Le choix d'utiliser la partie du rayonnement principal transmise au travers du substrat (mode « transmission ») ou la partie du rayonnement principal réfléchie par le revêtement (mode « réflexion »), ou éventuellement d'utiliser les deux, dépend de la nature du revêtement et de la longueur d'onde du rayonnement laser.

La température subie par le revêtement lors du traitement thermique est de préférence d'au moins 500°C, notamment 600°C, voire 700°C. Le démouillage ne s'accompagne normalement pas d'une fusion du métal, mais est dû à une augmentation thermiquement activée de la mobilité des atomes.

De préférence, la température du substrat au niveau de la face opposée à la face revêtue ne dépasse pas 100°C, notamment 50°C et même 30°C pendant le traitement thermique.

Le nombre de lignes laser peut être d'au moins 3, voire 4, ou même 5, ou encore 6, ou 7, voire 8, et même 9, ou encore 10 ou 11, en fonction de la largeur des substrats à traiter. Le nombre de lignes laser est de préférence compris entre 3 et 11 (bornes comprises), notamment entre 5 et 10 (bornes comprises).

Il est préférable que les lignes laser soient disposées de sorte que toute la surface de l'empilement puisse être traitée. Plusieurs dispositions sont envisageables selon la taille des lignes laser.

La ou chaque ligne laser est de préférence disposée perpendiculairement à la direction de défilement du substrat, ou disposé de manière oblique. Les lignes laser sont généralement parallèles entre eux. Les différentes lignes laser peuvent traiter le substrat simultanément, ou de manière décalée dans le temps. A titres d'exemples, les lignes laser peuvent être disposées en forme de V, en quinconce ou encore en épis.

Les lignes laser peuvent être disposées en rangs perpendiculaires à la direction de défilement du substrat. Le nombre de rangs est par exemple d'au moins 2, voire 3. Avantageusement, le nombre de rangs n'est pas supérieur à 3 pour limiter l'emprise au sol de la zone de traitement laser.

Pour s'assurer que le substrat soit concerné par le traitement dans sa totalité, il est préférable de disposer les lignes laser de manière à ce qu'il y ait un recouvrement, c'est-à-dire que certaines zones (de faible dimension, typiquement inférieure à 10 cm, voire 1 cm) soient traitées au moins deux fois.

Dans la direction de défilement du substrat, la distance entre deux lignes laser traitant des zones adjacentes est de préférence telle que les zones de recouvrement aient le temps de retourner à une température proche de l'ambiante pour éviter un endommagement du revêtement. Typiquement, la distance entre deux lignes laser traitant des zones adjacentes est avantageusement d'au moins trois fois la distance parcourue par un point de la couche sous la ligne laser.

Alternativement, les lignes laser peuvent être disposées sur une seule et même ligne (autrement dit le nombre de rangs est de 1). Dans ce cas, il est préférable de choisir un profil permettant d'obtenir une ligne laser continue et homogène au niveau du revêtement.

Le substrat peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Le moyen de convoyage comprend de préférence un châssis rigide et une pluralité de rouleaux. Le pas des rouleaux est avantageusement compris dans un domaine allant de 50 à 300 mm. Les rouleaux comprennent de préférence des bagues métalliques, typiquement en acier, recouvertes de bandages en matière plastique. Les rouleaux sont de préférence montés sur des paliers à jeu réduit, typiquement à raison de trois rouleaux par palier. Afin d'assurer une parfaite planéité du plan de convoyage, le positionnement de chacun des rouleaux est avantageusement réglable. Les rouleaux sont de préférence mus à l'aide de pignons ou de chaînes, de préférence de chaînes tangentielles, entraînés par au moins un moteur.

Si le substrat est en matière organique polymérique souple, le déplacement peut être réalisé à l'aide d'un système d'avance de films sous forme d'une succession de rouleaux. Dans ce cas, la planéité peut être assurée par un choix adéquat de la distance entre les rouleaux, en tenant compte de l'épaisseur du substrat (et donc de sa flexibilité) et de l'impact que peut avoir le traitement thermique sur la création d'une éventuelle flèche.

Toutes les positions relatives du substrat et des lignes laser sont bien entendu possibles, du moment que la surface du substrat peut être convenablement irradiée. Le substrat sera le plus généralement disposé de manière horizontale ou sensiblement horizontale, mais il peut aussi être disposé verticalement, ou selon toute inclinaison possible. Lorsque le substrat est disposé horizontalement, les lignes laser sont généralement disposées de manière à traiter la face supérieure du substrat. Les lignes laser peuvent également traiter la face inférieure du substrat. Dans ce cas, il faut que le système de convoyage du substrat laisse passer la chaleur vers la zone à traiter. C'est le cas par exemple lorsque l'on utilise des rouleaux de convoyage : les rouleaux étant disjoints, il est possible de disposer les lignes laser dans une zone située entre deux rouleaux successifs.

Lorsque les deux faces du substrat sont à traiter, il est possible d'employer plusieurs lignes laser situées de part et d'autre du substrat, que ce dernier soit en position horizontale, verticale, ou selon toute inclinaison. Ces lignes laser peuvent être identiques ou différentes, en particulier leurs longueurs d'onde peuvent être différentes, notamment adaptées à chacun des revêtements à traiter.

Le dispositif laser selon l'invention peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif laser est de préférence situé juste après l'installation de dépôt du revêtement, par exemple à la sortie de l'installation de dépôt. Le substrat revêtu peut ainsi être traité en ligne après le dépôt du revêtement, à la sortie de l'installation de dépôt et avant les dispositifs de contrôle optique, ou après les dispositifs de contrôle optique et avant les dispositifs d'empilage des substrats.

Le dispositif laser peut aussi, dans certains cas, être intégré à l'installation de dépôt. Par exemple, des sources laser peuvent être introduites dans une des chambres d'une installation de dépôt par pulvérisation cathodique, notamment dans une chambre où l'atmosphère est raréfiée, notamment sous une pression comprise entre 10⁻⁶ mbar et 10⁻² mbar. Le dispositif laser peut aussi être disposé en dehors de l'installation de dépôt, mais de manière à traiter un substrat situé à l'intérieur de ladite installation. On peut par exemple, dans le cas de l'utilisation de laser, prévoir à cet effet un hublot transparent à la longueur d'onde du rayonnement utilisé, au travers duquel le rayonnement laser viendrait traiter la couche.

Que le dispositif laser soit en dehors de ou intégré à l'installation de dépôt, ces procédés « en ligne » sont préférables à un procédé en reprise dans lequel il serait nécessaire d'empiler les substrats de verre entre l'étape de dépôt et le traitement laser.

Les procédés en reprise peuvent toutefois avoir un intérêt dans les cas où la mise en oeuvre du traitement laser est faite dans un lieu différent de celui où est réalisé le dépôt, par exemple dans un lieu où est réalisée la transformation du verre. Le dispositif laser peut donc être intégré à d'autres lignes que la ligne de dépôt de couches. Il peut par exemple être intégré à une ligne de fabrication de vitrages multiples (doubles ou triples vitrages notamment), à une ligne de fabrication de vitrages feuilletés, ou encore à une ligne de fabrication de vitrages bombés et/ou trempés. Les vitrages feuilletés ou bombés ou trempés peuvent être utilisés aussi bien en tant que vitrages bâtiment ou automobile. Dans ces différents cas, le traitement laser est de préférence réalisé avant la réalisation du vitrage multiple ou feuilleté. Le traitement laser peut toutefois être mis en oeuvre après réalisation du double vitrage ou du vitrage feuilleté.

Le dispositif laser est de préférence disposé dans une enceinte close permettant de sécuriser les personnes en évitant tout contact avec le rayonnement laser et d'éviter toute pollution, notamment du substrat, des optiques ou de la zone de traitement.

Le dépôt du revêtement sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel.

Le dépôt du revêtement est de préférence réalisé par pulvérisation cathodique, notamment assistée par champ magnétique (procédé magnétron).

Le substrat est de préférence en verre, en vitrocéramique ou en matière organique polymérique. Il est de préférence transparent, incolore (il s'agit alors d'un verre clair ou extra-clair) ou coloré, par exemple en bleu, gris, vert ou bronze. Le verre est de préférence de type silico-sodo-calcique, mais il peut également être en verre de type borosilicate ou alumino-borosilicate. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE).

Le substrat possède avantageusement au moins une dimension d'au moins 1 m, notamment 2 m, et même 3 m. L'épaisseur du substrat varie généralement entre 0,1 mm et 19 mm, de préférence entre 0,7 et 9 mm, notamment entre 2 et 8 mm, voire entre 4 et 6 mm. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, le revêtement à traiter peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Le substrat de verre peut également être obtenu par laminage entre deux rouleaux, technique permettant en particulier d'imprimer des motifs à la surface du verre.

Un autre objet de l'invention est l'utilisation d'un matériau selon l'invention comme polariseur réflectif ou comme filtre optique.

On entend par polariseur réflectif un polariseur capable de réfléchir une polarisation et de transmettre l'autre. Ce sont notamment les matériaux dont les motifs géométriques sont des lignes qui vont constituer les meilleurs polariseurs réflectifs. Dans ce cas, les rayonnements qui seront polarisés seront ceux dont la longueur d'onde est de l'ordre de la période des lignes. Selon la période obtenue, il est donc possible de polariser des rayonnements infrarouges ou visibles.

Les polariseurs réflectifs peuvent notamment être utilisés dans des dispositifs de visualisation à l'aide de cristaux liquides (notamment écrans du type LCD) ou encore des miroirs commutables. Des miroirs commutables peuvent notamment être obtenus à l'aide de deux polariseurs réflectifs superposés. De tels polariseurs réflectifs peuvent également être utilisés dans le domaine du bâtiment, afin de pouvoir régler à volonté le niveau de transmission ou de réflexion de vitrages.

Les filtres optiques peuvent trouver diverses applications, également dans le domaine des écrans de visualisation, ou encore dans le domaine du bâtiment, en tant que vitrage permettant de filtrer une partie de l'énergie solaire. La périodicité des motifs rend le filtre particulièrement efficace.

Un autre objet de l'invention est l'utilisation d'un matériau selon l'invention comme électrode, notamment pour cellules solaires. L'avantage du matériau selon l'invention dans ce type d'applications réside en sa forte transmission optique, la couche métallique ne couvrant pas la totalité de la surface du substrat.

Les matériaux selon l'invention peuvent aussi être utilisés dans des vitrages simples, multiples ou feuilletés, des miroirs, des revêtements muraux en verre. Dans le cas d'un vitrage multiple comportant au moins deux feuilles de verre séparées par une lame de gaz, il est préférable que l'empilement soit disposé sur la face en contact avec ladite lame de gaz, notamment en face 2 par rapport à l'extérieur (c'est-à-dire sur la face du substrat en contact avec l'extérieur du bâtiment qui est en opposée à la face tournée vers l'extérieur) ou en face 3 (c'est-à-dire sur la face du deuxième substrat en partant de l'extérieur du bâtiment tournée vers l'extérieur).

L'invention est illustrée à l'aide des figures et des exemples de réalisation non limitatifs qui suivent.
Les Figures 1 et 2 sont des clichés de matériaux selon l'invention par microscopie électronique à balayage.
Les Figures 3a et 3b sont des spectres en transmission et absorption de matériaux selon l'invention.

Sur un substrat de verre clair de 4 mm d'épaisseur, on a déposé de manière connue par pulvérisation cathodique magnétron l'empilement suivant :
Verre / Si₃N₄ (26) / TiO₂ (7) / ZnO (6) / Ag (11) / TiOₓ (1) / ZnO (6) / Si₃N₄ (35) / TiO₂ (2).

Les chiffres entre parenthèses correspondent aux épaisseurs physiques, exprimées en nanomètres. Toutes les couches sont continues.

Les formules données ne préjugent pas de la stoechiométrie exacte des composés formant les couches, ni d'un dopage éventuel. En l'occurrence, les couches de nitrure de silicium (appelées « Si₃N₄ ») contiennent également de l'aluminium, car la cible utilisée en contient.

Le substrat revêtu vient ensuite défiler sous une ligne laser disposée perpendiculairement à la direction de défilement afin de traiter le revêtement et de faire démouiller l'argent. La ligne est formée à l'aide de diodes laser de puissance. La puissance linéique du laser est de 490 W/cm.

La largeur de la ligne laser est d'environ 48 micromètres. Les longueurs d'onde utilisées sont de 913 et 980 nm.

Lorsque la vitesse de défilement est trop élevée (au-delà de 13 mètres par minute) la couche d'argent reste continue.

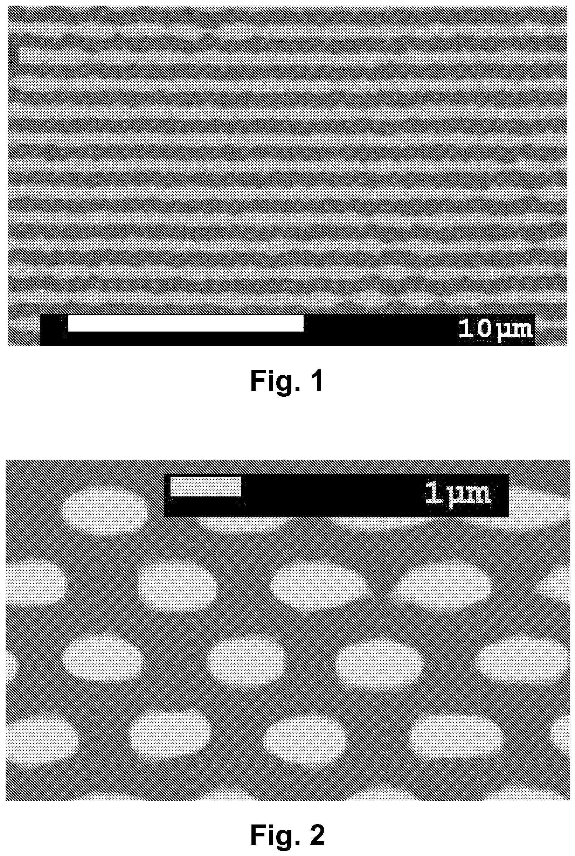

En diminuant la vitesse de défilement (en-deçà de 13 mètres par minute, notamment autour de 11,5 à 12,5 mètres par minute), la couche d'argent commente à démouiller et forme des lignes. La Figure 1 illustre ce mode de réalisation. Sur le cliché de microscopie électronique à balayage, les lignes claires correspondent à la couche d'argent, devenue discontinue et sous forme de lignes, s'étendant dans la direction de défilement du substrat, perpendiculairement à la ligne laser. Les lignes ont une largeur d'environ 1 µm, et sont régulièrement réparties, la période étant de l'ordre de 2 µm, donc de l'ordre du double de la longueur d'onde du laser.

Lorsque la vitesse de défilement est encore diminuée (vers 11 mètres par minute et en-deçà), les lignes d'argent se mettent à démouiller, jusqu'à former des gouttes. La Figure 2 illustre ce mode de réalisation. Les gouttes ont une forme sensiblement identique, proche de l'ellipse, et sont réparties de manière périodique. Le grand axe de l'ellipse possède une dimension d'environ 1 µm. Les motifs périodiques (gouttes) possèdent une périodicité selon plusieurs axes non parallèles entre eux. Chacune de ces gouttes est le centre d'un hexagone dont les sommets sont les six gouttes les plus proches de la goutte considérée.

Pour une vitesse de défilement encore plus faible, on observe une ablation du revêtement et même des couches superficielles du verre.

Les propriétés de polarisation du matériau comprenant des lignes comme motifs périodiques, et représenté en Figure 1, ont été testées de la manière qui suit. A l'aide d'un spectrophotomètre, on a mesuré le spectre en transmission et en réflexion pour chaque polarisation (s et p). Le spectre en absorption a été calculé à partir de ces deux spectres.

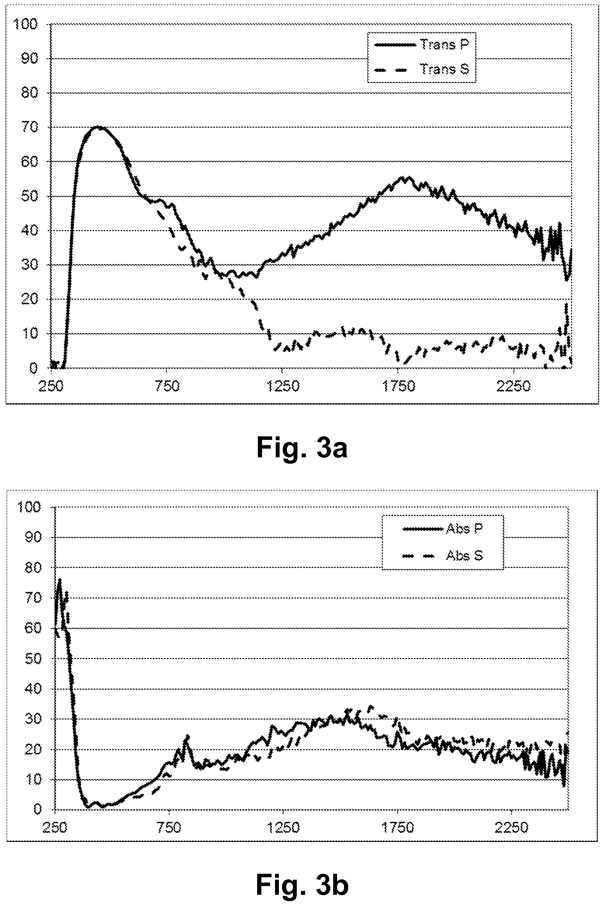

Les Figures 3a et 3b représentent respectivement le spectre en transmission et le spectre en absorption. Comme il est d'usage, la longueur d'onde (exprimée en nm) figure en abscisse et la valeur de transmission ou d'absorption (exprimée en pourcents) figure en ordonnée.

Le spectre en transmission montre que pour une longueur d'onde d'environ 1800 nm et pour une polarisation (dans le cas d'espèce la polarisation p, compte tenu de l'orientation du matériau) est transmise tandis que l'autre (ici la polarisation s) est peu transmise. Le spectre en absorption montre que cette dernière ne dépend pas de la polarisation : la polarisation s est donc réfléchie.

## Revendications

1. Procédé d'obtention d'un matériau comprenant un substrat revêtu sur au moins une partie d'au moins une de ses faces par un revêtement comprenant au moins une couche mince métallique discontinue à base d'argent, d'or, ou d'un quelconque de leurs alliages, la ou chaque couche mince métallique discontinue étant encapsulée entre au moins deux couches minces diélectriques, et la ou chaque couche mince métallique discontinue se présentant sous la forme de motifs géométriques périodiques, ledit procédé comprenant les étapes suivantes .
- on dépose sur au moins une partie d'au moins une face dudit substrat un revêtement comprenant au moins une couche mince métallique continue à base d'argent, d'or, ou d'un quelconque de leurs alliages, la ou chaque couche mince métallique continue étant encapsulée entre au moins deux couches minces diélectriques, puis
- on fait défiler le substrat ainsi revêtu en regard d'au moins un dispositif laser émettant un rayonnement laser focalisé sur ledit revêtement sous la forme d'au moins une ligne, la puissance dudit rayonnement étant adaptée afin de rendre discontinue la ou chaque couche mince métallique par démouillage.

2. Procédé selon la revendication précédente, tel que les motifs géométriques périodiques possèdent une période comprise dans un domaine allant de 0,1 à 10 micromètres, notamment de 0,3 à 5 micromètres.

3. Procédé selon l'une des revendications précédentes, dans lequel les motifs géométriques obtenus sont des lignes s'étendant dans la direction de défilement du substrat.

4. Procédé selon l'une des revendications 1 à 3, tel que les motifs périodiques possèdent une périodicité selon au moins deux axes non parallèles entre eux.

5. Procédé selon l'une des revendications précédentes, tel que l'épaisseur physique de la ou chaque couche mince métallique continue est comprise dans un domaine allant de 2 à 20 nm.

6. Procédé selon l'une des revendications précédentes, tel que la longueur d'onde du rayonnement laser est comprise dans un domaine allant de 200 à 2000 nm, notamment de 500 à 1500 nm.

7. Procédé selon l'une des revendications précédentes, tel que le rayonnement laser est continu.

8. Procédé selon l'une des revendications précédentes, tel que le substrat est en verre, en vitrocéramique, ou en matière organique polymérique.

9. Procédé selon l'une des revendications précédentes, tel que le revêtement comprend, à partir du substrat, un premier revêtement comprenant au moins une première couche diélectrique, au moins une couche mince métallique, éventuellement une couche de sur-bloqueur et un deuxième revêtement comprenant au moins une deuxième couche diélectrique.

10. Procédé selon la revendication précédente, tel que la première et/ou la deuxième couche diélectrique est en oxyde, notamment en oxyde d'étain ou de titane, ou en nitrure, notamment en nitrure de silicium.

11. Procédé selon l'une des revendications précédentes, tel que le substrat possède au moins une dimension d'au moins 1 m, notamment 2 m, et même 3 m.

12. Procédé selon l'une des revendications précédentes, tel que le dépôt du revêtement est réalisé par pulvérisation cathodique.

13. Matériau susceptible d'être obtenu selon le procédé de l'une des revendications précédentes, comprenant un substrat revêtu sur au moins une partie d'au moins une de ses faces par un revêtement comprenant au moins une couche mince métallique discontinue à base d'argent, d'or, ou d'un quelconque de leurs alliages, la ou chaque couche mince métallique discontinue étant encapsulée entre au moins deux couches minces diélectriques, et la ou chaque couche mince métallique discontinue se présentant sous la forme de motifs géométriques périodiques.

14. Utilisation d'un matériau selon la revendication 13 comme polariseur réflectif ou filtre.

15. Utilisation d'un matériau selon la revendication 13 comme électrode, notamment pour cellules solaires.

## Patentansprüche

1. Verfahren zur Herstellung eines Materials, umfassend ein Substrat, das auf mindestens einem Teil von mindestens einer seiner Seiten mit einer Beschichtung beschichtet wird, die mindestens eine dünne diskontinuierliche Metallschicht auf Basis von Silber, Gold oder einer beliebigen ihrer Legierungen aufweist, wobei die oder jede diskontinuierliche dünne Metallschicht zwischen mindestens zwei dünnen dielektrischen Schichten eingekapselt wird, und wobei die oder jede diskontinuierliche dünne Metallschicht die Form von regelmäßigen geometrischen Mustern aufweist, wobei das Verfahren die folgenden Schritte aufweist:
- Aufbringen auf mindestens einem Teil von mindestens einer Seite des Substrats einer Beschichtung, die mindestens eine dünne kontinuierliche Metallschicht auf Basis von Silber, Gold oder einer beliebigen ihrer Legierungen umfasst, wobei die oder jede kontinuierliche dünne Metallschicht zwischen mindestens zwei dünnen dielektrischen Schichten eingekapselt wird, und dann
- Vorbeiführen des auf diese Weise beschichteten Substrats vor mindestens einer Laservorrichtung, die eine Laserstrahlung emittiert, die auf die Beschichtung in Form von mindestens einer Linie fokussiert wird, wobei die Leistung der Strahlung geeignet ist, die oder jede dünne Metallschicht durch Entfeuchten diskontinuierlich zu machen.

2. Verfahren nach dem vorhergehenden Anspruch, derart, dass die regelmäßigen geometrischen Muster eine Periode aufweisen, die in einem Bereich von 0,1 bis 10 Mikrometer, insbesondere von 0,3 bis 5 Mikrometer, liegt.

3. Verfahren nach einem der vorhergehenden Ansprüche, wobei die erhaltenen geometrischen Muster Linien sind, die sich in der Durchlaufrichtung des Substrats erstrecken.

4. Verfahren nach einem der Ansprüche 1 bis 3, derart, dass die regelmäßigen Muster eine Periodizität entlang mindestens zwei Achsen, die zueinander nicht parallel sind, aufweisen.

5. Verfahren nach einem der vorhergehenden Ansprüche, derart, dass die physikalische Dicke der oder jeder dünnen kontinuierlichen Metallschicht in einem Bereich von 2 bis 20 nm liegt.

6. Verfahren nach einem der vorhergehenden Ansprüche, derart, dass die Wellenlänge der Laserstrahlung in einem Bereich von 200 bis 2.000 nm, insbesondere von 500 bis 1.500 nm, liegt.

7. Verfahren nach einem der vorangehenden Ansprüche, derart, dass die Laserstrahlung kontinuierlich ist.

8. Verfahren nach einem der vorangehenden Ansprüche, derart, dass das Substrat aus Glas, Glaskeramik oder aus organischem Polymermaterial ist.

9. Verfahren nach einem der vorangehenden Ansprüche, derart, dass die Beschichtung ausgehend von dem Substrat eine erste Beschichtung, umfassend mindestens eine erste dielektrische Schicht, mindestens eine dünne Metallschicht, eventuell eine Blockierschicht, und eine zweite Beschichtung aufweist, umfassend mindestens eine zweite dielektrische Schicht.

10. Verfahren nach dem vorhergehenden Anspruch, derart, dass die erste und/oder die zweite dielektrische Schicht aus Oxid, insbesondere aus Zinn- oder Titanoxid, oder aus Nitrid, insbesondere aus Siliziumnitrid, ist.

11. Verfahren nach einem der vorangehenden Ansprüche, derart, dass das Substrat mindestens eine Abmessung von mindestens 1 m, insbesondere 2 m, und sogar 3 m, aufweist.

12. Verfahren nach einem der vorhergehenden Ansprüche, derart, dass das Aufbringen der Beschichtung durch Kathodenzerstäubung durchgeführt wird.

13. Material, das geeignet ist, nach dem Verfahren nach einem der vorhergehenden Ansprüche erhalten zu werden, umfassend ein Substrat, das auf mindestens einem Teil von mindestens einer seiner Seiten mit einer Beschichtung beschichtet ist, die mindestens eine dünne diskontinuierliche Metallschicht auf Basis von Silber, Gold oder einer beliebigen ihrer Legierungen aufweist, wobei die oder jede diskontinuierliche dünne Metallschicht zwischen mindestens zwei dünnen dielektrischen Schichten eingekapselt ist, und wobei die oder jede diskontinuierliche dünne Metallschicht die Form von regelmäßigen geometrischen Mustern aufweist.

14. Verwendung eines Materials nach Anspruch 13 als reflektierender Polarisator oder Filter.

15. Verwendung eines Materials nach Anspruch 13 als Elektrode, insbesondere für Solarzellen.

## Claims

1. A process for obtaining a material comprising a substrate coated on at least one portion of at least one of its faces with a coating comprising at least one discontinuous metallic thin layer based on silver, on gold, or on any alloy thereof, the or each discontinuous metallic thin layer being encapsulated between at least two dielectric thin layers, and the or each discontinuous metallic thin layer being in the form of periodic geometric patterns, said process comprising the following steps:
- deposited on at least one portion of at least one face of said substrate is a coating comprising at least one continuous metallic thin layer based on silver, on gold, or on any alloy thereof, the or each continuous metallic thin layer being encapsulated between at least two dielectric thin layers, then
- the substrate thus coated is made to run opposite at least one laser device emitting a laser radiation focused on said coating in the form of at least one line, the power of said radiation being adapted in order to render the or each metallic thin layer discontinuous by dewetting.

2. The process as claimed in the preceding claim, such that the periodic geometric patterns have a period within a range extending from 0.1 to 10 micrometers, in particular from 0.3 to 5 micrometers.

3. The process as claimed in one of the preceding claims, wherein the geometric patterns obtained are lines extending in the run direction of the substrate.

4. The process as claimed in one of claims 1 to 3, such that the periodic patterns have a periodicity along at least two axes that are not parallel to one another.

5. The process as claimed in one of the preceding claims, such that the physical thickness of the or each continuous metallic thin layer is within a range extending from 2 to 20 nm.

6. The process as claimed in one of the preceding claims, such that the wavelength of the laser radiation is within a range extending from 200 to 2000 nm, in particular from 500 to 1500 nm.

7. The process as claimed in one of the preceding claims, such that the laser radiation is continuous.

8. The process as claimed in one of the preceding claims, such that the substrate is made of glass, of glass-ceramic or of a polymeric organic material.

9. The process as claimed in one of the preceding claims, such that the coating comprises, starting from the substrate, a first coating comprising at least a first dielectric layer, at least a metallic thin layer, optionally an overblocker layer and a second coating comprising at least a second dielectric layer.

10. The process as claimed in the preceding claim, such that the first and/or second dielectric layer is an oxide, in particular tin oxide or titanium oxide, or a nitride, in particular silicon nitride.

11. The process as claimed in one of the preceding claims, such that the substrate has at least one dimension of at least 1 m, in particular 2 m, and even 3 m.

12. The process as claimed in one of the preceding claims, such that the coating is deposited by sputtering.

13. A material capable of being obtained as claimed in the process from one of the preceding claims, comprising a substrate coated on at least one portion of at least one of its faces with a coating comprising at least one discontinuous metallic thin layer based on silver, on gold, or on any alloy thereof, the or each discontinuous metallic thin layer being encapsulated between at least two dielectric thin layers, and the or each discontinuous metallic thin layer being in the form of periodic geometric patterns.

14. The use of a material as claimed in claim 13, as reflective polarizer or filter.

15. The use of a material as claimed in claim 13, as electrode, in particular for solar cells.
